# EUROPEAN PATENT SPECIFICATION

(11) **EP 3 185 022 B1**
(45) Date of publication and mention of the grant of the patent: **28.08.2019**
(21) Application number: 16202171.1
(22) Date of filing: 05.12.2016
(51) Int. Cl.: G01R 23/02, G01R 29/08, G01R 29/10, G01R 31/02

(54) **METHOD AND CIRCUIT FOR DETERMINING ANTENNA STATE, ANTENNA TUNER AND WIRELESS COMMUNICATOR**
VERFAHREN UND SCHALTUNG ZUR BESTIMMUNG DES ANTENNENZUSTANDS, ANTENNENTUNER UND DRAHTLOSER KOMMUNIKATOR
PROCÉDÉ ET CIRCUIT PERMETTANT DE DÉTERMINER UN ÉTAT D'ANTENNE, UN ADAPTATEUR D'ANTENNE ET UN DISPOSITIF DE COMMUNICATION SANS FIL

(30) Priority: 14.12.2015 JP 2015242994
(43) Date of publication of application: 28.06.2017
(73) Proprietor: Furuno Electric Company Limited, Hyogo (JP)
(72) Inventor: KANEYUKI, Hiroshi, Nishinomiya-shi, Hyogo (JP)
(74) Representative: CSY London

(56) References cited:
- CN-A- 103 123 371
- JP-A- 2008 224 522
- JP-A- 2012 175 399
- US-A1- 2008 007 432
- US-A1- 2010 283 477
- Irving Gottlieb: "The op amp square-wave oscillator" In: "Practical Oscillator Handbook", 12 June 1997 (1997-06-12), Elsevier Science, XP055373429, ISBN: 978-0-7506-3102-0 pages 192-194, * the whole document *

## Description

### Technical Field

This disclosure relates to an antenna state determining circuit which determines whether an antenna is properly connected or is in an abnormal state, such as open- or short-circuit, and also relates to an antenna matching circuit including the antenna state determining circuit.

### Background of the Invention

Conventionally, various devices and methods for monitoring and detecting a state of an antenna have been provided.

JP3889007B2 discloses an antenna state monitoring device which measures consumed power of a transmission signal power amplifying circuit, and if the consumed power is abnormal, determines that the antenna is not operating normally.

JP2014-064221A and JP1994-296168A disclose obstacle detecting methods which measure a reflection power from an antenna to detect an abnormality of the antenna.

JP2008-022233A discloses an abnormality detecting device which detects an abnormality of an antenna based on a current passing through the antenna.

US 2008/0007432 discloses a diagnosis apparatus for diagnosing a connection state of a vehicle antenna which is used to communicate with a portable key. A transceiver circuit performs transmission and reception of signals to and from the portable key, via a vehicle antenna. Diagnosis of whether the antenna is normally connected to the transceiver circuit is carried out by a CPU. The determination of whether or not the antenna is connected is achieved by detecting whether a drive voltage or a drive current is less than a predetermined value, even if a command to drive the antenna is outputted from the CPU.

US2010/0283477 discloses a detection circuit which is used to determine whether a pair of contacts are in electrical contact with a conducting member. The detection circuit includes a resonating circuit connected to the contacts. The oscillation frequencies in the detection circuit are different depending upon whether or not the contacts are electrically connected to the conducting member. Depending upon the differences between the frequency values of the detection circuit, an electronic processing module delivers data to the outside representing the electrical condition of at least one of the contacts.

JP 2008 224522 discloses an antenna connection diagnosis device for determining the connection state of an antenna mounted on a car body. The device has an oscillation circuit, and transistors configured to switch between two antennas.

However, with these devices and methods, the antenna state cannot be detected unless a transmission signal is transmitted to the antenna. Further, when the transmission or reception frequency band is wide, it is not easy to accurately grasp the antenna state for the entire band with these devices and methods. Moreover if the transmission power is high, a reflection signal may damage a detection circuit and a transmission circuit.

### Summary of the Invention

The purpose of the present disclosure relates to providing an antenna state determining circuit which is not easily influenced by a configuration of a transmission signal and capable of accurately determining a state of an antenna, and an antenna tuner including this circuit.

According to one aspect of the present invention there is provided an antenna state determining circuit as defined in claim 1.

In the above configuration, depending on the state of the antenna, impedance of the feedback circuit differs as well as the oscillation frequency differs. For example, if the antenna is in a normal state, impedance of the antenna is applied to the feedback circuit and the oscillation frequency changes compared with a state where the antenna is not connected. If the antenna is an open-circuit state, the impedance of the antenna is not applied to the feedback circuit and the oscillation frequency does not change compared with the state where the antenna is not connected. If the antenna is a short-circuit state, the feedback circuit is grounded to stop the oscillation, that is, the oscillation frequency becomes "0." In this manner, by measuring the oscillation frequency, it is possible to determine the state of the antenna.

The validity state determining module may determine that the antenna is in a normal state when the first frequency is different from the second frequency and the second frequency is a non-zero value.

Alternatively or in addition, the validity state determining module may determine that the antenna is in an abnormal state when the first frequency is the same as the second frequency or when the second frequency is zero.

The validity state determining module may determine that the antenna is in an open-circuit state when the first frequency is the same as the second frequency.

The validity state determining module may determine that the antenna is in a short-circuit state when the second frequency is zero.

The oscillation circuit may be an LC oscillation circuit in which an inductor is connected to a capacitor, or an RC oscillation circuit in which a resistance is connected to a capacitor, each of the inductor, the resistance, and the capacitor being an element of the feedback circuit.

The oscillation frequency may be lower than the frequency of the communication signal.

According to another aspect of the invention, an antenna tuner is provided. The antenna tuner includes the antenna state determining circuit described above. A variable matching circuit may be located between a transmission circuit configured to generate the communication signal and the antenna connector to be connected thereto. The antenna connector may connect the antenna to the feedback circuit or the variable matching circuit.

The antenna tuner may further include a controller configured to control an impedance of the variable matching circuit. The controller may include the validity state determining module.

When the antenna is determined to be in the abnormal state, the controller may control the antenna connector or the transmission circuit to stop the generation of the communication signal.

According to another aspect of the invention, a wireless communicator is provided. The wireless communicator includes the antenna tuner described above. The frequency of the communication signal is preferably within an MF band or an HF band.

According to another aspect of the invention there is provided, a method of determing a state of an antenna of a wireless communicator as defined in claim 13.

The determining process may include determining that the antenna is in a normal state when the first frequency is different from the second frequency and the second frequency is a non-zero value. The determining process may include determining that the antenna is in an abnormal state when the first frequency is the same as the second frequency or the second frequency is zero.

The determining process may include determining that the antenna is in an open-circuit state when the first frequency is the same as the second frequency. The determining process may include determining that the antenna is in a short-circuit state when the second frequency is zero.

### Effects of the Invention

According to this disclosure, a validity state of an antenna is accurately determined while being less influenced by a configuration of a transmission signal.

### Brief Description of the Drawings

The present disclosure is illustrated by way of example and not by way of limitation in the figures of the accompanying drawings, in which the like reference numerals indicate like elements and in which:
Fig. 1 is a functional block diagram of a wireless communicator including an antenna state determining circuit according to one embodiment of this disclosure;
Fig. 2 shows views illustrating a concept of detection of an antenna state of this disclosure;
Fig. 3 is a flowchart illustrating a first mode of an antenna state determining method according to the embodiment;
Fig. 4 is a flowchart illustrating a second mode of the antenna state determining method according to the embodiment;
Fig. 5 is a flowchart illustrating a third mode of the antenna state determining method according to the embodiment; and
Fig. 6 is a flowchart illustrating a fourth mode of the antenna state determining method according to the embodiment.

### Detailed Description of the Invention

An antenna state determining circuit, an antenna tuner, a wireless communicator, and an antenna state determining method according to one embodiment of this disclosure are described with reference to the appended drawings.

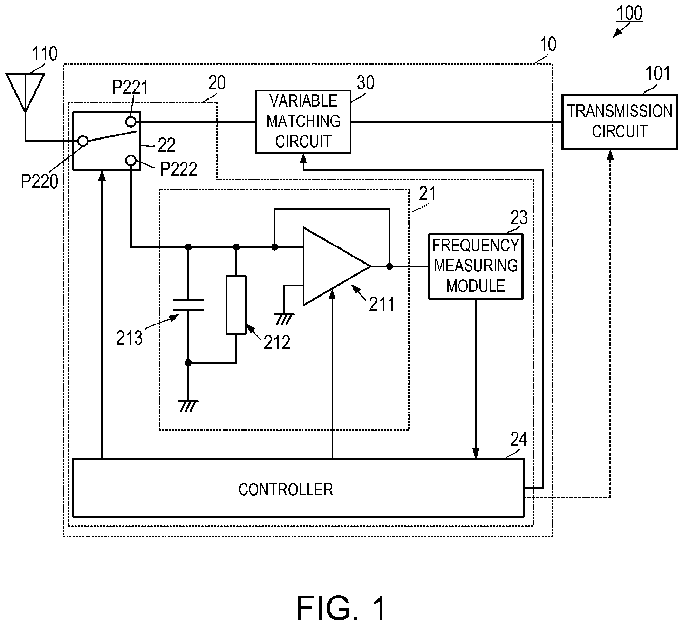

As illustrated in Fig. 1, a wireless communicator 100 (which may also be referred to as a radio communicator 100) includes an antenna 110, a transmission circuit 101, and an antenna tuner 10. The antenna tuner 10 includes an antenna state determining circuit 20 and a variable matching circuit 30. Note that the wireless communicator 100 transmits communication signals of frequencies within an MF band and an HF band. This wireless communicator 100 is used for communications of ships etc., and transmits communication signals with high power at a given frequency selected from a wide frequency band forming the MF band and the HF band (frequency band from 1.6 to 27MHz). As an example, this wireless communicator 100 may be, for example, an MH/HF radiotelephone.

The antenna state determining circuit 20 includes an oscillation circuit 21, a switch 22, a frequency measurer 23 (which may also be referred to as a frequency measuring module 23), and a controller 24. The switch 22 corresponds to "the antenna connector."

The oscillation circuit 21 includes an operational amplifier 211, an impedance element 212, and a capacitor 213. The oscillation circuit 21 may be an oscillation circuit of a negative feedback type or an oscillation circuit of a positive feedback type, which use the operational amplifier 211. Fig. 1 illustrates the oscillation circuit of the negative feedback type.

An inverting input terminal of the operational amplifier 211 is grounded via a parallel circuit of the impedance element 212 and the capacitor 213. The impedance element 212 is an inductor or a resistance. A non-inverting input terminal of the operational amplifier 211 is directly grounded. Note that the non-inverting input terminal may be grounded via a resistance etc. An output terminal of the operational amplifier 211 is connected to the inverting input terminal. A feedback circuit which is a base of the oscillation circuit 21 is constructed by such a structure. A resistance etc. may be connected to a path connecting the output terminal to the inverting input terminal. The output terminal of the operational amplifier 211 is connected to the frequency measurer 23. The frequency measurer 23 is connected to the controller 24.

A control terminal (drive voltage application terminal) of the operational amplifier 211 is connected to the controller 24. The controller 24 applies a voltage for oscillation control (causing oscillation) to the control terminal of the operational amplifier 211.

The switch 22 includes a common terminal P220 and selected terminals P221 and P222. The switch 22 connects the common terminal P220 to one of the selected terminals P221 and P222 based on a switch control signal from the controller 24. The common terminal P220 is connected to the antenna 110. The selected terminal P221 is connected to the transmission circuit 101 via the variable matching circuit 30. The selected terminal P222 is connected to a feedback circuit connected to the inverting input terminal of the operational amplifier 211, to be more exact, terminals of the impedance element 212 and the capacitor 213 opposite from the grounded side.

The frequency measurer 23 measures the frequency of the output signal of the oscillation circuit 21. The frequency measurer 23 outputs the measured frequency to the controller 24.

The controller 24 determines a validity state of the antenna 110 based on the frequency measured by the frequency measurer 23. That is, the controller 24 has a function of "the validity state determining module." Note that the specific method of determining the validity state of the antenna 110 is described later.

When determining the antenna validity state, the controller 24 oscillates the oscillation circuit 21 by supplying the voltage for the oscillation control. On the other hand, when the determination of the antenna validity state is not required, the controller 24 stops the oscillation of the oscillation circuit 21 by stopping the supply of the voltage for the oscillation control.

The controller 24 executes a control of switching the connection of the switch 22 by outputting a switch control signal to the switch 22. For example, when determining the antenna validity state, the controller 24 outputs the switch control signal to connect the common terminal P220 to the selected terminal P222. When the determination of the antenna validity state is not required, the controller 24 outputs the switch control signal to connect the common terminal P220 to the selected terminal P221.

The controller 24 generates an impedance control signal to adjust impedance of the variable matching circuit 30 based on the frequency of the communication signal transmitted by the wireless communicator 100.

The variable matching circuit 30 is capable of varying the impedance according to the impedance control signal from the controller 24, and achieves an impedance match between the transmission circuit 101 and the antenna 110 (to be more exact, a circuit including the antenna 110 and the switch 22).

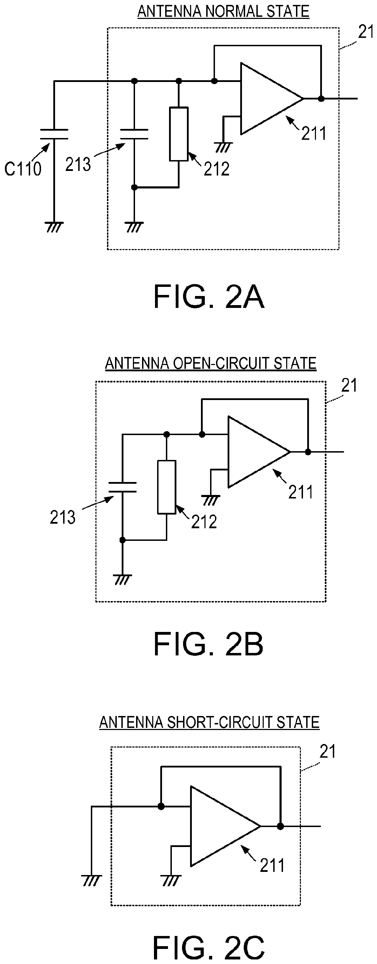

In this configuration, the antenna state determining circuit 20 detects the validity state of the antenna 110 as follows. Fig. 2 shows views illustrating a concept of the detection of an antenna state of this disclosure. Part (A) of Fig. 2 illustrates an equivalent circuit when the antenna is in a normal state, Part (B) of Fig. 2 illustrates an equivalent circuit when the antenna is in an open-circuit state, and Part (C) of Fig. 2 illustrates an equivalent circuit when the antenna is in a short-circuit state. The open-circuit state of the antenna is a state where the antenna 110 is not connected to the common terminal P220 of the switch 22, i.e., the antenna tuner 10. The short-circuit state of the antenna is a state where the antenna 110 is in contact with a conductive body, such as a hull, and grounded unintentionally.

The antenna 110 is expressed as a capacitor C110 of the equivalent circuit within a frequency band below the communication frequency of the wireless communicator 100. Note that although the antenna 110 has a low resistance component which is linearly connected to the capacitor C110, it is omitted here.

When the antenna 110 is in the normal state, as illustrated in Part (A) of Fig. 2, the capacitor C110 of the antenna 110 is connected parallel to the impedance element 212 and the capacitor 213. Therefore, the frequency of the output signal of the oscillation circuit 21 is determined based on the impedance of the impedance element 212 and capacitances of the capacitors 213 and C110.

When the antenna 110 is in the open-circuit state, as illustrated in Part (B) of Fig. 2, the antenna 110 is not connected to the impedance element 212 and the capacitor 213. Therefore, the frequency of the output signal of the oscillation circuit 21 is determined based on the impedance of the impedance element 212 and the capacitance of the capacitor 213.

Note that the state where the common terminal P220 of the switch 22 is connected to the selected terminal P221, i.e., the state where the antenna 110 is connected to the transmission circuit 101 via the variable matching circuit 30, is the same as the open-circuit state of the antenna 110 as illustrated in Part (B) of Fig. 2 in terms of equivalent circuit. Therefore, in the state where the antenna 110 is connected to the transmission circuit 101 via the variable matching circuit 30, the frequency of the output signal of the oscillation circuit 21 is determined based on the impedance of the impedance element 212 and the capacitance of the capacitor 213.

When the antenna 110 is in the short-circuit state, as illustrated in Part (C) of Fig. 2, the inverting and non-inverting input terminals of the operational amplifier 211 are both grounded. Therefore, the oscillation of the oscillation circuit 21 stops and an oscillation signal is not outputted, which is the same as the frequency of the output signal being "0."

For example, a case is considered where the impedance element 212 is an inductor, the inductance thereof is L212, the capacitance of the capacitor 213 is C213, and the capacitance of the antenna 110 is CC110.

In this case, when the antenna 110 is normal, the oscillation frequency is 1/(2π√(L212·(C213+CC110))). When the antenna 110 is in the open-circuit state or not connected to the oscillation circuit 21, the oscillation frequency is 1/(2π√(L212·C213)). When the antenna 110 is in the short-circuit state, the oscillation frequency is "0."

When the controller 24 detects that the frequency is 1/(2π√L212·(C213+CC110))) in the state where the common terminal P220 of the switch 22 is connected to the selected terminal P222, it determines that the antenna 110 is in the normal state.

When the controller 24 detects that the frequency is 1/(2π√(L212·C213)) or the frequency is "0" in the state where the common terminal P220 of the switch 22 is connected to the selected terminal P222, it determines that the antenna 110 is in the abnormal state. Further as needed, when the controller 24 detects that the frequency is 1/(2π√(L212·C213)) in the state where the common terminal P220 of the switch 22 is connected to the selected terminal P222, it determines that the antenna 110 is in the open-circuit state. Moreover, when the controller 24 detects that the frequency is "0" in the state where the common terminal P220 of the switch 22 is connected to the selected terminal P222, it determines that the antenna 110 is in the short-circuit state.

By using the configuration of this embodiment as above, the validity state of the antenna 110 is determined.

Further, by using the configuration of this embodiment, since the frequency for the determination of the validity state of the antenna 110 is different from the frequency for the wireless communication of the wireless communicator 100, even if the frequency band of the wireless communication is wide, it is possible to accurately and reliability determine the validigy state of the antenna 110 regardlessly.

Further, by using the configuration of this embodiment, since the validity state of the antenna 110 is determined even without the transmission signal which is the communication signal, the transmission circuit 101 is prevented from being damaged by the transmission signal. Especially with a wireless communicator of which the transmission signal has high power (transmission power), a damage easily occurs due to reflection power of the transmission signal etc. By using the configuration of this embodiment, such damage is also prevented.

Further with the configuration of this embodiment, the controller 24 adjusts the impedance of the antenna tuner 10 and determines the validity state of the antenna 110. In other words, the state determining module configured to determine the validity state of the antenna 110 is included in the controller 24 which adjusts the impedance of the antenna tuner 10. Thus the circuit structure which determines the validity state of the antenna 110 is combined with the circuit structure of the antenna tuner 10 disposed directly below the antenna 110, and the number of components of the functional part of the control system is reduced. Thus, it is possible to simplify more the circuit structure of the antenna tuner 10 having the determining function for the validity state of the antenna 110, and as a result, a size reduction is achieved.

Note that in the above description, the inductor is used as the impedance element 212; however, also by using a resistance, it is possible to determine the validity state of the antenna 110 with the similar method.

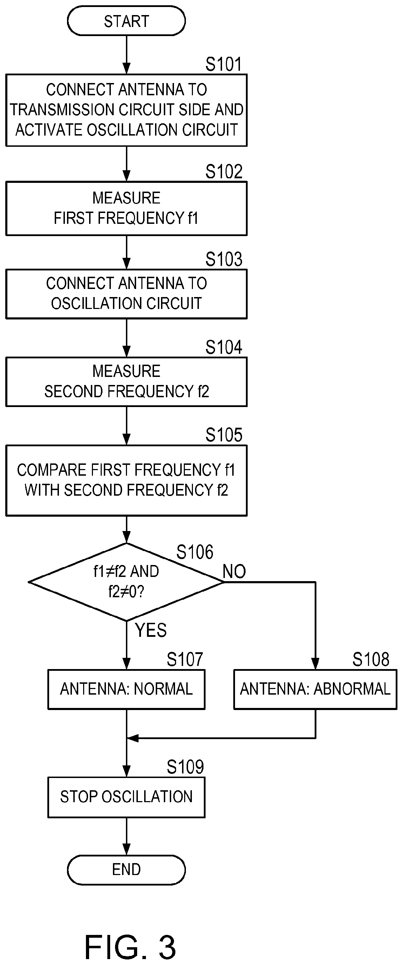

The antenna state determining circuit 20 described above determines the validity state of the antenna 110 by the flow as follows. Fig. 3 is a flowchart illustrating a first mode of the antenna state determining method according to the embodiment.

The controller 24 controls the switch 22 to start the oscillation circuit 21 in the state where the antenna 110 is connected to the transmission side, i.e., the state where the antenna 110 is not connected to the oscillation circuit 21 (S101). This state corresponds to "the first connection state."

The frequency measurer 23 measures the frequency of the output signal from the oscillation circuit 21 in the first connection state, as a first frequency fl (S102). Here, the frequency measurer 23 measures the first frequency fl in a state where a given time lapsed since the start of the oscillation circuit 21 and the frequency of the output signal of the oscillation circuit 21 is stable.

The controller 24 controls the switch 22 to connect the antenna 110 to the oscillation circuit 21 (S 103). This state corresponds to "the second connection state."

The frequency measurer 23 measures the frequency of the output signal from the oscillation circuit 21 in the second connection state, as a second frequency f2 (S104). Here, the frequency measurer 23 measures the second frequency f2 in a state where a given time lapsed since the antenna 110 is connected to the oscillation circuit 21 and the frequency of the output signal of the oscillation circuit 21 is stable.

The controller 24 compares the first frequency fl with the second frequency f2 (S105). If a determination condition defined by the first frequency fl being different from the second frequency f2 (f1 ≠ f2) and the second frequency f2 not being "0" (f2 ≠ 0) (S106: YES), the controller 24 determines that the validity state of the antenna 110 is normal (S107). Note that the first frequency fl is determined as different from the second frequency f2 (f1 ≠ f2) not only when they are completely different. For example, the first frequency f1 may be determined as different from the second frequency f2 (f1 ≠ f2) when the difference between the first frequency fl and the second frequency f2 is above a given threshold.

If the determination condition is not satisfied (S106: NO), the controller 24 determines that the validity state of the antenna 110 is abnormal (S108).

The controller 24 stops the oscillation of the oscillation circuit 21 once the determination of the validity state of the antenna 110 is finished (S109).

By using the antenna state determining method of this embodiment as above, it is possible to accurately and reliably determine the validity state of the antenna 110 as described above.

Further, by using the antenna state determining method of the first mode, the frequency measured in the state where the antenna 110 is not connected to the oscillation circuit 21 may be used as a reference. Therefore, it is possible to reduce the influence which the oscillation frequency of the oscillation circuit 21 receives due to the environment in which the validity state of the antenna 110 is determined, and determine more accurately the validity state of the antenna 110.

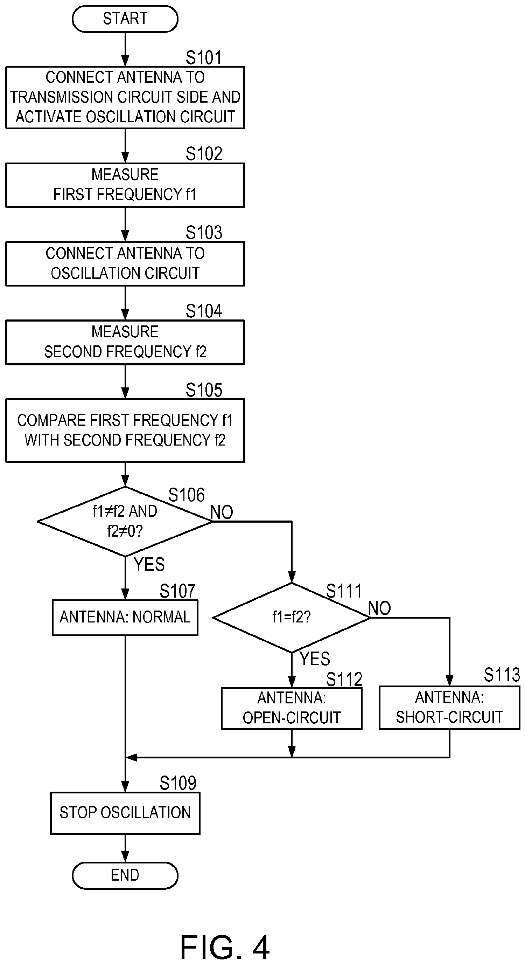

Fig. 4 is a flowchart illustrating a second mode of the antenna state determining method according to this embodiment. The antenna state determining method in Fig. 4 is for a more detailed determination when the validity state of the antenna is abnormal compared to the first mode illustrated in Fig. 3. Therefore, the antenna state determining method in Fig. 4 is the same as the first mode illustrated in Fig. 3 except for this determination processing in the abnormal state, and description of the same processing is omitted.

If the determination condition of whether the antenna validity state is normal is not satisfied (S106: NO), whether the first frequency fl is the same as the second frequency f2 is determined. Here, the controller 24 determines whether the first frequency fl is the same as the second frequency f2 not only based on whether they are completely the same. For example, when the difference between the first frequency fl and the second frequency f2 is below a given threshold, the first frequency fl may be determined as the same as the second frequency f2 (f1=f2).

If this open-circuit state determination condition that the first frequency fl is the same as the second frequency f2 (f1=f2) is satisfied (S111: YES), the controller 24 determines that the antenna 110 is in the open-circuit state (S112). If the open-circuit state determination condition is not satisfied (S111: NO), the controller 24 determines that the antenna 110 is in the short-circuit state (S113).

By this processing, it is possible to determine, not only that the antenna validity state is abnormal, but also whether it is in the open-circuit state or the short-circuit state. Thus, a user can grasp the abnormal state of the antenna 110 more in detail, and recovery operation becomes easier.

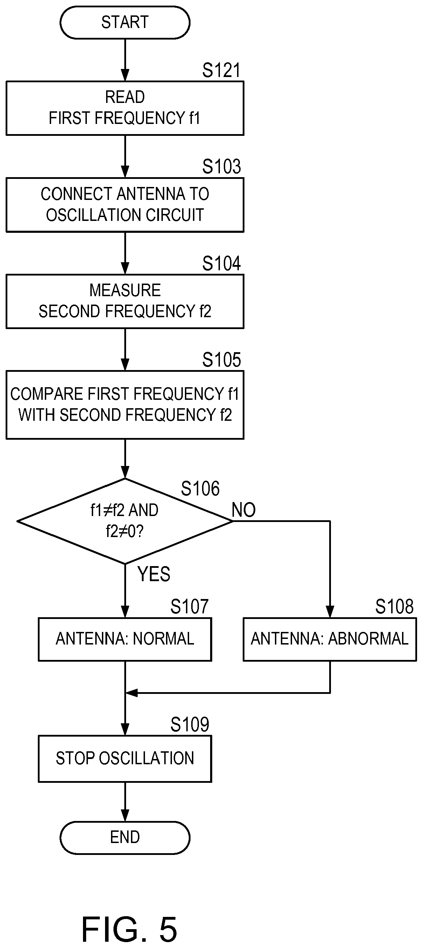

Fig. 5 is a flowchart illustrating a third mode of the antenna state determining method according to this embodiment. The antenna state determining method in Fig. 5 is different from that illustrated in Fig. 3 in the acquiring method of the first frequency fl. Other processing of the antenna state determining method in Fig. 5 is the same as the antenna state determining method illustrated in Fig. 3, and description of the same processing is omitted.

The controller 24 acquires and stores the oscillation frequency of the oscillation circuit 21 in the state where the antenna 110 is not connected, as the first frequency fl. For example the controller 24 stores an oscillation frequency set based on the design of the oscillation circuit 21, as the first frequency fl.

The controller 24 reads the stored first frequency fl (S121). Then, the controller 24 acquires the second frequency f2 with the processing of the antenna state determine method illustrated in Fig. 3, and determines the validity state of the antenna 110.

By using this processing, it is possible to shorten the acquisition time of the oscillation frequency which is the reference, and determine more quickly the validity state of the antenna 110.

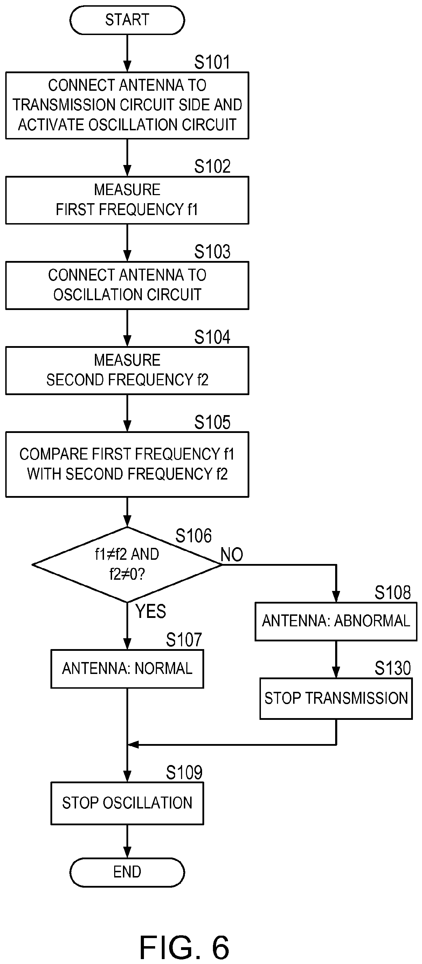

Fig. 6 is a flowchart illustrating a fourth mode of the antenna state determining method according to this embodiment. The antenna state determining method in Fig. 6 is the antenna state determining method illustrated in Fig. 3 with a transmission stop control added thereto. Other processing of the antenna state determining method in Fig. 6 is the same as the antenna state determining method illustrated in Fig. 3, and description of the same processing is omitted.

When the antenna validity state is determined as abnormal (S108), the controller 24 executes the transmission stop control (S130). For example, the controller 24 controls the transmission circuit 101 of the wireless communicator 100 to stop the generation of the transmission signal. Further for example, the controller 24 controls the switch 22 not to connect the antenna 110 to the variable matching circuit 30.

By using this processing, the operations and effects described above are achieved and unnecessary generation of the transmission signal is prevented.

Note that in the above description, the mode in which the oscillation circuit 21 is oscillated only when determining the antenna validity state is described; however, the oscillation circuit 21 may be oscillated constantly. However, by oscillating the oscillation circuit 21 only when determining the antenna validity state, it is possible to reduce the influence which the transmission signal receives from the signal outputted by the oscillation circuit 21, and lower power consumption.

Moreover in the above description, the mode in which the oscillation frequency of the oscillation circuit 21 is lower than the frequency of the communication signal of the wireless communicator 100 is described; however, also when it is above the frequency of the communication signal, it is possible to determine the validity state of the antenna by using the similar concept. Note that when the oscillation frequency of the oscillation circuit 21 is lower than the frequency of the communication signal of the wireless communicator 100, the antenna 110 definitely becomes the capacitor (Capacitive) in the equivalent circuit. Therefore, it is possible to determine more stably the antenna validity state.

Moreover in the above description, the oscillation frequency of the oscillation circuit 21 is simply described as lower than the frequency of the communication signal of the wireless communicator 100; however, it is desirable that the number of digits is different from each other. For example, the oscillation frequency of the oscillation circuit 21 is desirably about between 10kHz and 100kHz. In this case, it is possible to determine the antenna validity state more stably. Additionally, by using such an oscillation frequency, it is possible to prevent the signal from being outputted from the antenna to determine the antenna validity state. Although it is not illustrated, a resistance may be disposed between the antenna and the oscillation circuit. In this case, current flowing to the antenna from the oscillation circuit is restricted.

Moreover in the above description, the mode in which the operational amplifier is used for the oscillation circuit is described; however, an IC provided with a comparator as a package may be used. Alternatively, the oscillation circuit may be structured by connecting a feedback circuit to an amplifying element, such as a transistor, without using the operational amplifier.

Further, each mode of the processing method described above may suitably be combined with another.

## Claims

1. An antenna state determining circuit (20) for determining a validity state of an antenna (110) of a wireless communicator (100), the wireless communicator including a transmission circuit (101) configured to generate a transmission signal,
**characterized in that** the antenna state determining circuit comprises:
an oscillation circuit (21) having a feedback circuit and an oscillation frequency different from a frequency of the transmission signal of the transmission circuit (101);
an antenna connector (22) configured to switch a connection state of the antenna (110) between a first connection state in which the antenna (110) is disconnected from the feedback circuit, and a second connection state in which the antenna (110) is connected to the feedback circuit and disconnected from the transmission circuit (101);
a frequency measuring module (23) configured to measure a first frequency (f1) of the oscillation frequency when the connection state is the first connection state and a second frequency (f2) of the oscillation frequency when the connection state is the second connection state; and
a validity state determining module (24) configured to determine the validity state of the antenna (110) based on the first frequency (f1) and the second frequency (f2).

2. The antenna state determining circuit (20) of claim 1, wherein the validity state determining module (24) is arranged to determine that the antenna (110) is in a normal state when the first frequency (f1) is different from the second frequency (f2) and the second frequency (f2) is a non-zero value.

3. The antenna state determining circuit (20) of claim 1 or 2, wherein the validity state determining module (24) is arranged to determine that the antenna (110) is in an abnormal state when the first frequency (f1) is the same as the second frequency (f2) or when the second frequency (f2) is zero.

4. The antenna state determining circuit (20) of claim 3, wherein the validity state determining module (24) is arranged to determine that the antenna (110) is in an open-circuit state when the first frequency (f1) is the same as the second frequency (f2).

5. The antenna state determining circuit (20) of claim 3, wherein the validity state determining module (24) is arranged to determine that the antenna (110) is in a short-circuit state when the second frequency (f2) is zero.

6. The antenna state determining circuit (20) of any one of claims 1 to 5, wherein the oscillation circuit (21) is an LC oscillation circuit in which an inductor (212) is connected to a capacitor (213), or an RC oscillation circuit in which a resistance (212) is connected to a capacitor (213), each of the inductor (212), the resistance (212), and the capacitor (213) being an element of the feedback circuit.

7. The antenna state determining circuit (20) of any one of claims 1 to 6, wherein the oscillation frequency is lower than the frequency of the transmission signal of the transmission circuit.

8. An antenna tuner (10), comprising:
the antenna state determining circuit (20) of any one of claims 1 to 7; and
a variable matching circuit (30) located between the transmission circuit (101) and the antenna connector (22),
wherein the antenna connector (22) is arranged to connect the antenna (110) to the feedback circuit or the variable matching circuit (30).

9. The antenna tuner (10) of claim 8, further comprising
a controller (24) configured to control an impedance of the variable matching circuit (30), and which includes the validity state determining module (24).

10. The antenna tuner (10) of claim 9, wherein the controller (24) is configured to control the antenna connector (22) or the transmission circuit (101) to stop the generation of the transmission signal when the antenna (110) is determined to be in the abnormal state.

11. A wireless communicator (100), comprising:
the antenna state determining circuit (20) of any of claims 1 to 7, or the antenna tuner (10) of any of claims 8 to 10; and
the transmission circuit (101) configured to generate the transmission signal.

12. The wireless communicator (100) of claim 11, wherein the frequency of the transmission signal is within an MF band or an HF band.

13. A method of determining a validity state of an antenna (110) of a wireless communicator (100), the wireless communicator including a transmission circuit (101) configured to generate a transmission signal,
**characterized in that** the method comprises:
a process of measuring a first frequency (f1) of an oscillation frequency of an oscillation circuit (21), the oscillation frequency being different from a frequency of the transmission signal of the transmission circuit (101), when a connection state of the antenna (110) is in a first connection state in which the antenna (110) is disconnected from a feedback circuit of the oscillation circuit (21);
a process of measuring a second frequency (f2) of the oscillation frequency when the connection state of the antenna (110) is in a second connection state in which the antenna (110) is connected to the feedback circuit and disconnected from the transmission circuit (101); and
a process of determining the validity state of the antenna (110) based on the first frequency (f1) and the second frequency (f2).

14. The method of determining the validity state of the antenna (110) of claim 13, wherein the determining process includes determining that the antenna (110) is in a normal state when the first frequency (f1) is different from the second frequency (f2) and the second frequency (f2) is a non-zero value, and
wherein the determining process includes determining that the antenna (110) is in an abnormal state when the first frequency (f1) is the same as the second frequency (f2) or the second frequency (f2) is zero.

15. The method of determining the validity state of the antenna (110) of claim 14, wherein the determining process includes determining that the antenna (110) is in an open-circuit state when the first frequency (f1) is the same as the second frequency (f2), and
wherein the determining process includes determining that the antenna (110) is in a short-circuit state when the second frequency (f2) is zero.

## Patentansprüche

1. Antennenzustandsfeststellungsschaltung (20) zum Feststellen eines Validitätszustands einer Antenne (110) eines drahtlosen Kommunikators (100), wobei der drahtlose Kommunikator eine Sendeschaltung (101) enthält, die konfiguriert ist, um ein Sendesignal zu erzeugen,
**dadurch gekennzeichnet, dass** die Antennenzustandsfeststellungsschaltung aufweist:
einen Schwingkreis (21), der einen Rückführkreis und eine Schwingungsfrequenz hat, die von einer Frequenz des Sendesignals der Sendeschaltung (101) verschieden ist;
einen Antennenverbinder (22), der konfiguriert ist, um einen Verbindungszustand der Antenne (110) zwischen einem ersten Verbindungszustand, in dem die Antenne (110) von dem Rückführkreis getrennt ist, und einem zweiten Verbindungszustand, in dem die Antenne (110) mit dem Rückführkreis verbunden und von der Sendeschaltung (101) getrennt ist, zu schalten;
ein Frequenzmessmodul (23), das konfiguriert ist, um eine erste Frequenz (f1) der Schwingungsfrequenz zu messen, wenn der Verbindungszustand der erste Verbindungszustand ist, und eine zweite Frequenz (f2) der Schwingungsfrequenz zu messen, wenn der Verbindungszustand der zweite Verbindungszustand ist; und
ein Validitätszustandsfeststellungsmodul (24), das konfiguriert ist, um den Validitätszustand der Antenne (110) basierend auf der ersten Frequenz (f1) und der zweiten Frequenz (f2) festzustellen.

2. Antennenzustandsfeststellungsschaltung (20) nach Anspruch 1, bei der das Validitätszustandsfeststellungsmodul (24) ausgebildet ist, um festzustellen, dass die Antenne (110) in einem Normalzustand ist, wenn die erste Frequenz (f1) von der zweiten Frequenz (f2) verschieden und die zweite Frequenz (f2) ein Nicht-Null-Wert ist.

3. Antennenzustandsfeststellungsschaltung (20) nach Anspruch 1 oder 2, bei der das Validitätszustandsfeststellungsmodul (24) ausgebildet ist, um festzustellen, dass die Antenne (110) in einem abnormalen Zustand ist, wenn die erste Frequenz (f1) die gleiche wie die zweite Frequenz (f2) ist oder wenn die zweite Frequenz (f2) Null ist.

4. Antennenzustandsfeststellungsschaltung (20) nach Anspruch 3, bei der das Validitätszustandsfeststellungsmodul (24) ausgebildet ist, um festzustellen, dass die Antenne (110) in einem Zustand eines offenen Schaltkreises ist, wenn die erste Frequenz (f1) die gleiche wie die zweite Frequenz (f2) ist.

5. Antennenzustandsfeststellungsschaltung (20) nach Anspruch 3, bei der das Validitätszustandsfeststellungsmodul (24) ausgebildet ist, um festzustellen, dass die Antenne (110) in einem Kurzschlusszustand ist, wenn die zweite Frequenz (f2) Null ist.

6. Antennenzustandsfeststellungsschaltung (20) nach einem der Ansprüche 1 bis 5, bei der der Schwingungskreis (21) ein LC-Schwingungskreis ist, in dem ein Induktor (212) mit einem Kondensator (213) verbunden ist, oder ein RC-Schwingungskreis ist, in dem ein Widerstand (212) mit einem Kondensator (213) verbunden ist, wobei der Induktor (212), der Widerstand (212) und der Kondensator (213) jeweils ein Element des Rückführkreises sind.

7. Antennenzustandsfeststellungsschaltung (20) nach einem der Ansprüche 1 bis 6, bei der die Schwingungsfrequenz niedriger als die Frequenz des Sendesignals der Sendeschaltung ist.

8. Antennentuner (10), der aufweist:
die Antennenzustandsfeststellungsschaltung (20) nach einem der Ansprüche 1 bis 7; und
eine variable Anpassungsschaltung (30), die zwischen der Sendeschaltung (101) und dem Antennenverbinder (22) angeordnet ist,
wobei der Antennenverbinder (22) ausgebildet ist, um die Antenne (110) mit dem Rückführkreis oder der variablen Anpassungsschaltung (30) zu verbinden.

9. Antennentuner (10) nach Anspruch (8), außerdem mit
einer Steuerungseinrichtung (24) die konfiguriert ist, um eine Impedanz der variablen Anpassungsschaltung (30) zu steuern, und die das Validitätszustandsfeststellungsmodul (24) enthält.

10. Antennentuner (10) nach Anspruch 9, bei dem die Steuerungseinrichtung (24) konfiguriert ist, um den Antennenverbinder (22) oder die Sendeschaltung (101) zu steuern, um die Erzeugung des Sendesignals zu stoppen, wenn festgestellt wird, dass die Antenne (110) in dem abnormalen Zustand ist.

11. Drahtloser Kommunikator (100), der aufweist:
die Antennenzustandsfeststellungsschaltung (20) nach einem der Ansprüche 1 bis 7 oder den Antennentuner (10) nach einem der Ansprüche 8 bis 10; und
die Sendeschaltung (101), die konfiguriert ist, um das Sendesignal zu erzeugen.

12. Drahtloser Kommunikator (100) nach Anspruch 11, bei dem die Frequenz des Sendesignals innerhalb eines MF-Bandes oder eines HF-Bandes ist.

13. Verfahren zum Feststellen eines Validitätszustands einer Antenne (110) eines drahtlosen Kommunikators (100), wobei der drahtlose Kommunikator eine Sendeschaltung (100) enthält, die konfiguriert ist, um ein Sendesignal zu erzeugen,
**dadurch gekennzeichnet, dass** das Verfahren aufweist:
ein Verfahren zum Messen einer ersten Frequenz (f1) einer Schwingungsfrequenz einer Schwingungsschaltung (21), wobei die Schwingungsfrequenz von einer Frequenz des Sendesignals der Sendeschaltung (101) verschieden ist, wenn ein Verbindungszustand der Antenne (110) in einem ersten Verbindungszustand ist, in dem die Antenne (110) von einem Rückführkreis der Schwingungsschaltung (21) getrennt ist;
ein Verfahren zum Messen einer zweiten Frequenz (f2) der Schwingungsfrequenz, wenn der Verbindungszustand der Antenne (110) in einem zweiten Verbindungszustand ist, in dem die Antenne (110) mit dem Rückführkreis verbunden und von der Sendeschaltung (101) getrennt ist; und
ein Verfahren zum Feststellen des Validitätszustands der Antenne (110) basierend auf der ersten Frequenz (f1) und der zweiten Frequenz (f2).

14. Verfahren zum Feststellen des Validitätszustands der Antenne (110) nach Anspruch 13, bei dem das Feststellungsverfahren die Feststellung beinhaltet, dass die Antenne (110) in einem Normalzustand ist, wenn die erste Frequenz (f1) von der zweiten Frequenz (f2) verschieden und die zweite Frequenz (f2) ein Nicht-Null-Wert ist, und
bei dem das Feststellungsverfahren die Feststellung beinhaltet, dass die Antenne (110) in einem abnormalen Zustand ist, wenn die erste Frequenz (f1) die gleiche wie die zweite Frequenz (f2) ist oder die zweite Frequenz (f2) Null ist.

15. Verfahren zum Feststellen des Validitätszustands der Antenne (110) nach Anspruch 14, bei dem das Feststellungsverfahren die Feststellung beinhaltet, dass die Antenne (110) in einem Zustand eines offenen Schaltkreises ist, wenn die erste Frequenz (f1) die gleiche wie die zweite Frequenz (f2) ist, und
bei dem das Feststellungsverfahren die Feststellung beinhaltet, dass die Antenne (110) in einem Kurzschlusszustand ist, wenn die zweite Frequenz (f2) Null ist.

## Revendications

1. Un circuit de détermination d'état d'antenne (20) destiné à la détermination d'un état de validité d'une antenne (110) d'un dispositif de communication sans fil (100), le dispositif de communication sans fil comprenant un circuit de transmission (101) configuré de façon à générer un signal de transmission,
**caractérisé en ce que** le circuit de détermination d'état d'antenne comprend :
un circuit d'oscillation (21) possédant un circuit de rétroaction et une fréquence d'oscillation différente d'une fréquence du signal de transmission du circuit de transmission (101),
un connecteur d'antenne (22) configuré de façon à commuter un état de connexion de l'antenne (110) entre un premier état de connexion dans lequel l'antenne (110) est déconnectée du circuit de rétroaction et un deuxième état de connexion dans lequel l'antenne (110) est raccordée au circuit de rétroaction et déconnectée du circuit de transmission (101),
un module de mesure de fréquence (23) configuré de façon à mesurer une première fréquence (f1) de la fréquence d'oscillation lorsque l'état de connexion est le premier état de connexion et une deuxième fréquence (f2) de la fréquence d'oscillation lorsque l'état de connexion est le deuxième état de connexion, et
un module de détermination d'état de validité (24) configuré de façon à déterminer l'état de validité de l'antenne (110) en fonction de la première fréquence (f1) et de la deuxième fréquence (f2).

2. Le circuit de détermination d'état d'antenne (20) selon la Revendication 1, où le module de détermination d'état de validité (24) est agencé de façon à déterminer que l'antenne (110) est dans un état normal lorsque la première fréquence (f1) est différente de la deuxième fréquence (f2) et la deuxième fréquence (f2) est une valeur non nulle.

3. Le circuit de détermination d'état d'antenne (20) selon la Revendication 1 ou 2, où le module de détermination d'état de validité (24) est agencé de façon à déterminer que l'antenne (110) est dans un état anormal lorsque la première fréquence (f1) est la même que la deuxième fréquence (f2) ou lorsque la deuxième fréquence (f2) est nulle.

4. Le circuit de détermination d'état d'antenne (20) selon la Revendication 3, où le module de détermination d'état de validité (24) est agencé de façon à déterminer que l'antenne (110) est dans un état de circuit ouvert lorsque la première fréquence (f1) est la même que la deuxième fréquence (f2).

5. Le circuit de détermination d'état d'antenne (20) selon la Revendication 3, où le module de détermination d'état de validité (24) est agencé de façon à déterminer que l'antenne (110) est dans un état de court-circuit lorsque la deuxième fréquence (f2) est nulle.

6. Le circuit de détermination d'état d'antenne (20) selon l'une quelconque des Revendications 1 à 5, où le circuit d'oscillation (21) est un circuit d'oscillation LC dans lequel un inducteur (212) est raccordé à un condensateur (213), ou un circuit d'oscillation RC dans lequel une résistance (212) est raccordée à un condensateur (213), chaque élément parmi l'inducteur (212), la résistance (212) et le condensateur (213) étant un élément du circuit de rétroaction.

7. Le circuit de détermination d'état d'antenne (20) selon l'une quelconque des Revendications 1 à 6, où la fréquence d'oscillation est inférieure à la fréquence du signal de transmission du circuit de transmission.

8. Un dispositif d'accord d'antenne (10), comprenant :
le circuit de détermination d'état d'antenne (20) selon l'une quelconque des Revendications 1 à 7, et
un circuit d'appariement variable (30) situé entre le circuit de transmission (101) et le connecteur d'antenne (22),
où le connecteur d'antenne (22) est agencé de façon à raccorder l'antenne (110) au circuit de rétroaction ou au circuit d'appariement variable (30).

9. Le dispositif d'accord d'antenne (10) selon la Revendication 8, comprenant en outre
un dispositif de commande (24) configuré de façon à commander une impédance du circuit d'appariement variable (30), et qui comprend le module de détermination d'état de validité (24).

10. Le dispositif d'accord d'antenne (10) selon la Revendication 9, où le dispositif de commande (24) est configuré de façon à commander le connecteur d'antenne (22) ou le circuit de transmission (101) de façon à arrêter la génération du signal de transmission lorsque l'antenne (110) est déterminée être dans l'état anormal.

11. Un dispositif de communication sans fil (100), comprenant :
le circuit de détermination d'état d'antenne (20) selon l'une quelconque des Revendications 1 à 7, ou le dispositif d'accord d'antenne (10) selon l'une quelconque des Revendications 8 à 10, et
le circuit de transmission (101) configuré de façon à générer le signal de transmission.

12. Le dispositif de communication sans fil (100) selon la Revendication 11, où la fréquence du signal de transmission est à l'intérieur d'une bande MF ou d'une bande HF.

13. Un procédé de détermination d'un état de validité d'une antenne (110) d'un dispositif de communication sans fil (100), le dispositif de communication sans fil comprenant un circuit de transmission (101) configuré de façon à générer un signal de transmission,
**caractérisé en ce que** le procédé comprend :
un procédé de mesure d'une première fréquence (f1) d'une fréquence d'oscillation d'un circuit d'oscillation (21), la fréquence d'oscillation étant différente d'une fréquence du signal de transmission du circuit de transmission (101) lorsqu'un état de connexion de l'antenne (110) est dans un premier état de connexion dans lequel l'antenne (110) est déconnectée d'un circuit de rétroaction du circuit d'oscillation (21),
un procédé de mesure d'une deuxième fréquence (f2) de la fréquence d'oscillation lorsque l'état de connexion de l'antenne (110) est dans un deuxième état de connexion dans lequel l'antenne (110) est raccordée au circuit de rétroaction et déconnectée du circuit de transmission (101), et
un procédé de détermination de l'état de validité de l'antenne (110) en fonction de la première fréquence (f1) et de la deuxième fréquence (f2).

14. Le procédé de détermination de l'état de validité de l'antenne (110) selon la Revendication 13, où le procédé de détermination comprend la détermination que l'antenne (110) est dans un état normal lorsque la première fréquence (f1) est différente de la deuxième fréquence (f2) et la deuxième fréquence (f2) est une valeur non nulle, et
où le procédé de détermination comprend la détermination que l'antenne (110) est dans un état anormal lorsque la première fréquence (f1) est la même que la deuxième fréquence (f2) ou que la deuxième fréquence (f2) est nulle.

15. Le procédé de détermination de l'état de validité de l'antenne (110) selon la Revendication 14, où le procédé de détermination comprend la détermination que l'antenne (110) est dans un état de circuit ouvert lorsque la première fréquence (f1) est la même que la deuxième fréquence (f2), et
où le procédé de détermination comprend la détermination que l'antenne (110) est dans un état de court-circuit lorsque la deuxième fréquence (f2) est nulle.
